Europäisches Patentamt

European Patent Office

Office européen des brevets

(11) Publication number: **0 430 950 B1**

# EUROPEAN PATENT SPECIFICATION

(45) Date of publication of patent specification: **29.09.93**  (51) Int. Cl.5: **G01R 1/28,** G08C 15/08

(21) Application number: **89907118.7**

(22) Date of filing: **10.06.89**

(86) International application number:
**PCT/EP89/00655**

(87) International publication number:
**WO 90/15338 (13.12.90 90/28)**

(54) **REFERENCE-VOLTAGE SUPPLY CIRCUIT.**

(43) Date of publication of application:
**12.06.91 Bulletin  91/24**

(45) Publication of the grant of the patent:
**29.09.93 Bulletin  93/39**

(84) Designated Contracting States:
**DE FR GB**

(56) References cited:
**DE-A- 3 513 848
DE-C- 3 401 905
US-A- 4 706 157**

(73) Proprietor: **ROBERT BOSCH GMBH
Postfach 30 02 20
D-70442 Stuttgart(DE)**

(72) Inventor: **KLEINHANS, Josef
Gerokstrasse 1/2
D-7143 Vaihingen/Enz(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(3.10/3.6/3.3.1)

## Description

The present invention relates to a circuit arrangement for supplying a reference voltage, in particular to a sensor having a voltage output.

With sensors which give a voltage output, errors frequently arise in the evaluation of the output when the sensor and the evaluating circuitry, e.g. a computer, are spatially separated. The present invention seeks to overcome or reduce this problem.

According to the present invention there is provided a voltage supply circuit for a sensor having a sensor-output receiving circuit with a reference-voltage source, characterised in that a switch is connected between the output (Ua) of the sensor and the receiving circuit, and that a sampling circuit is connected to a point between the switch and the receiving circuit, the sampling circuit being arranged, when the switch is open, to receive a reference voltage from the source of the receiving circuit.

An advantage of this circuit is increased accuracy since sensor and receiving circuit have a common reference voltage. The location of the reference voltage source is not critical, so that it can be placed well away from disturbing influences such as heat sources.

Preferably the sampling circuit is a sample and hold circuit which is controlled at the same frequency as the switch and which has a reference voltage output. This involves a time-multiplex operation and ensures that the connection between the sensor and receiving circuit is in permanent use.

The circuit may advantageously employed in a sensor which operates in a pulsed manner. Where a comparator receives as a first input the output of the sensor and as a second input a signal determined by a threshold circuit, the upper and lower thresholds may be determined by the reference voltage and can be used to determine the limits of the range of output voltage values. The sensor may be a hot film air mass meter.

Preferred embodiments of the present invention will now be described, by way of example only, with reference to the accompanying drawings, of which:

Fig.1 is a circuit diagram of a first embodiment of the present invention;

Fig.2 shows signal curves associated with the circuit of Fig.1;

Fig.3 shows a circuit diagram of a second embodiment of the present invention for use with a hot film air mass meter; and

Fig.4 shows signal curves associated with the circuit of Fig.3.

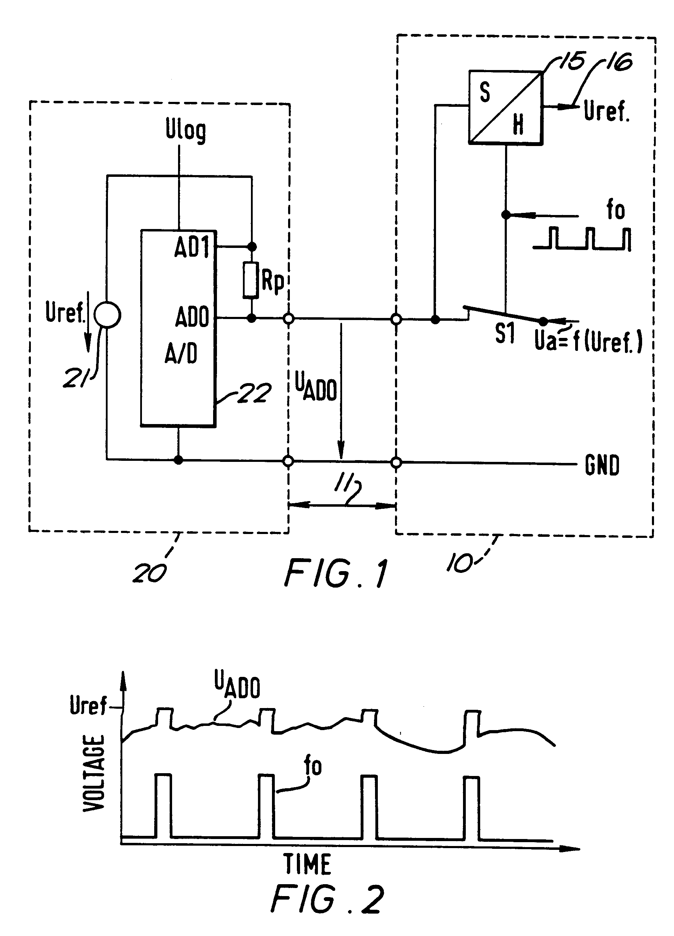

Referring now to Fig.1 there is shown a sensor connected by means of a transmission path 11 to an evaluating circuit, e.g. a computer 20. The output Ua of the sensor is connected via a switch S1 and the transmission path 11 to the input ADO of an analogue to digital converter 22 in the evaluation circuit 20. The input ADO is connected via a pull-up-resistor Rp to a source 21 of reference voltage Uref.

The side of switch S1 remote from the sensor output Ua is connected to a sample and hold circuit 15. Switch S1 and circuit 15 are controlled by a common frequency fo. During the period when switch S1 is open the reference voltage Uref is supplied to the sample input of circuit 15; accordingly an output 16 of the sample and hold circuit can be used as a reference voltage source for further operations within the sensor 10. During this sampling phase, the evaluating circuit 20 can ignore the A/D value; alternatively the mark/space ratio of the sampling frequency fo is made so small that the errors introduced by application of the reference frequency can be ignored.

The above embodiment has a number of advantages. It has increased accuracy since there is only one reference voltage source. In addition costs are reduced. Moreover, the effects of external conditions such as temperature on the circuit can be reduced because the location of the reference voltage source is not important for the operation of the circuit.

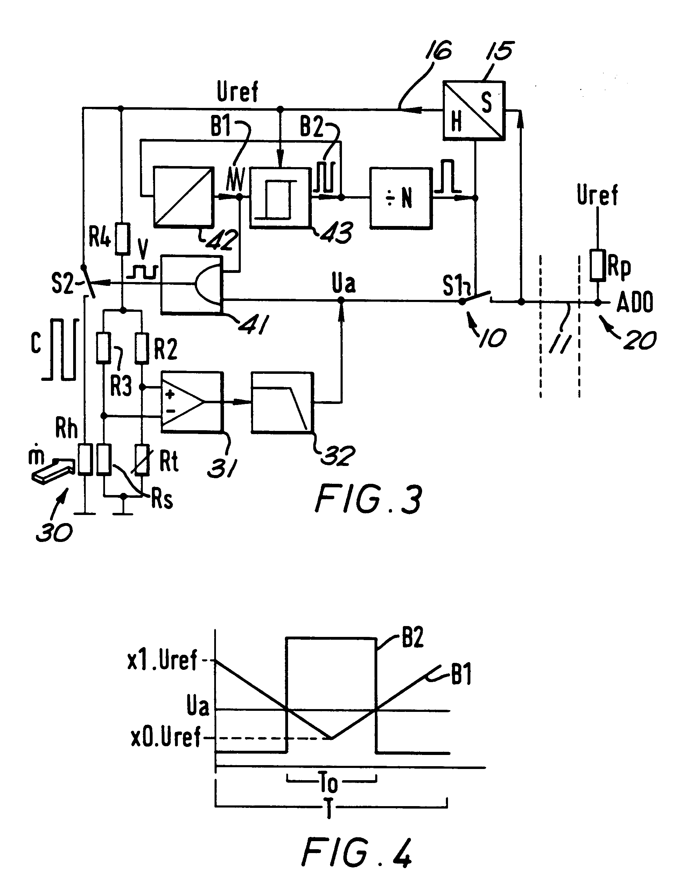

Referring now to Fig. 3, there is shown a circuit as described in connection with Figs 1 and 2 in combination with a hot film air mass meter 30. The air mass meter is of the pulsed type (such as that disclosed in DE-A-3803608, the contents of which are hereby incorporated by reference) and the pulse frequency can be used for reading of the reference voltage. This is controlled by the output of a frequency divider 35.

The signal from the air mass meter is supplied via a differential amplifier 31 and a low-pass filter 32 to form an output Ua which is supplied to both switch S1 and to the first input of a comparator 41. The mark-space ratio v at the output of the comparator is a function of the air mass, ie. $v = v(m)$. It is this output which is used to control the operation of a switch S2 for the clock supply to C to the air mass meter.

The second input of comparator 41 is determined by an integrator 42 and a threshold circuit 43. The respective outputs B1, B2 of the circuits are shown in Fig.4. The upper and lower threshold values of circuit 3 are determined by the reference voltage Uref obtained from the evaluating or control circuit 20. Taking the upper limit as the product of x1 and the reference voltage, and the lower limit as the product of x0 and the reference voltage, Fig. 4 shows the relationship between the various signals. It will be seen that:

$$\frac{To}{T} = v(m) = \frac{Ua - x0 \cdot Uref}{(x1 - x0) \cdot Uref}$$

From which it can be derived that

Ua = [x0 k v . (x1 - x0)] . Uref

Thus Ua is directly proportional to the reference Uref of the control device 20. The range of output voltages can only be set as desired by means of the two thresholds. For example, by selecting

x0 . Uref = 0,2 V
x1 . Uref = 4,5 V

and by noting that in always lies between 0 and 1, it will be seen that Ua also lies in the range 0.2 to 4.5 volts.

Although described in connection with a hot film air mass meter, the circuit of the present invention may be used in connection of a wide range of types of sensor.

## Claims

1. A voltage supply circuit for a sensor (10) having a sensor-output receiving circuit (20) with a reference-voltage source (21), characterised in that a switch (S1) is connected between the output (Ua) of the sensor (10) and the receiving circuit (20), and that a sampling circuit (15) is connected to a point between the switch (S1) and the receiving circuit (20), the sampling circuit (15) being arranged, when the switch (S1) is open, to receive a reference voltage (Uref) from the source (21) of the receiving circuit (20).

2. A circuit according to claim 1, wherein the sampling circuit (15) is a sample and hold circuit which is controlled at the same frequency (fo) as the switch (S1) and which has a reference voltage output (16).

3. A circuit according to claim 1 or 2, wherein the receiving circuit comprises an analogue-to-digital converter (22) having an input (ADO) connected to the reference voltage source (22) via a resistor (Rp).

4. A circuit according to any preceding claim, wherein the output (Ua) of the sensor is supplied to a first input of a comparator (41), the second input of which receives a signal fluctuating between two values determined by the reference voltage (Uref).

5. A circuit according to claim 4, wherein the second input of the comparator (41) is connected to the output of an integrating circuit (42) which is also connected to a threshold circuit (43), the threshold circuit being connected to the output of the sampling circuit (15) and determining said two values.

6. A circuit according to claim 4 or 5 wherein the supply to the sensor (10) is of the pulsed-type and the output of the comparator (41) has a mark-space ratio (v) and controls a second switch (S2) which supplies in pulsed manner the reference voltage (Uref) to the sensor.

7. A circuit according to any of claims 4 to 6, wherein the output of the comparator (41) is connected to a frequency divider (35) the output of which controls the first switch (S1) and the sampling circuit (15).

8. A circuit according to any preceding claim, wherein the sensor is hot film air mass meter (30).

## Patentansprüche

1. Spannungsversorgungsschaltung für einen Sensor (10) mit einem Sensorausgangs-Empfangsschaltkreis (20) mit einer Referenzspannungsquelle (21), dadurch gekennzeichnet, daß ein Schalter (S1) zwischen den Ausgang (Ua) des Sensors (10) und den Empfangsschaltkreis (20) geschaltet ist und daß ein Sammelschaltkreis (15) mit einem Punkt zwischen dem Schalter (S1) und dem Empfangsschaltkreis (20) verbunden ist, daß der Sammelschaltkreis (15) so angeordnet ist, daß er bei geöffnetem Schalter (S1) eine Referenzspannung (Uref) von der Referenzspannungsquelle (21) des Empfangsschaltkreises (20) empfängt.

2. Schaltung nach Anspruch 1, bei der die Sammelschaltung (15) eine Sammel- und Halteschaltung ist, die auf dieselbe Frequenz (f0) geregelt wird wie der Schalter (S1) und die einen Referenzspannungsausgang (16) aufweist.

3. Schaltung nach Anspruch 1 oder 2, bei der der Empfangskreis einen Analog-Digital-Wandler (22) umfaßt, mit einem Eingang (ADO), der mit der Referenzspannungsquelle (22) über einen Widerstand (Rp) verbunden ist.

4. Schaltung nach einem der vorhergehenden Ansprüche, bei der der Ausgang (Ua) des Sensors an einen ersten Eingang eines Komparators (41) gelegt ist, dessen zweiter Eingang ein Signal empfängt, das zwischen zwei Werten schwankt, die durch die Referenzspannung (Uref) festgelegt sind.

5. Schaltung nach Anspruch 4, bei der der zweite Eingang des Komparators (41) mit dem Ausgang eines integrierenden Schaltkreises (42) verbunden ist, der weiterhin mit einem Schwellwertschaltkreis (43) verbunden ist, wobei der Schwellwertschaltkreis mit dem Ausgang des Halteschaltkreises (15) verbunden ist und die beiden Werte festlegt.

6. Schaltung nach Anspruch 4 oder 5, bei der der Sensor (10) an einer gepulsten Versorgung liegt und der Ausgang des Komparators (41) ein Puls-Pause-Verhältnis (V) aufweist und einen zweiten Schalter (S2) steuert, welcher die Referenzspannung (Uref) in gepulster Weise dem Sensor zuführt.

7. Schaltung nach einem der Ansprüche 4 bis 6, bei der der Ausgang des Komparators (41) mit einem Freguenzteiler (35) verbunden ist, dessen Ausgang den ersten Schalter (S1) und den Sammelschaltkreis (15) steuert.

8. Schaltung nach einem der vorhergehenden Ansprüche wobei der Sensor ein Heißfilmluftmassenmesser (30) ist.

**Revendications**

1. Circuit d'alimentation en tension d'un détecteur (10) comportant un circuit de réception de sortie de détecteur (20) muni d'une source de tension de référence (21), circuit caractérisé en ce qu'un commutateur (S1) est branché entre la sortie (Ua) du détecteur (10) et le circuit de réception (20), et en ce qu'un circuit d'échantillonnage (15) est branché à un point situé entre le commutateur (S1) et le circuit de réception (20), ce circuit d'échantillonnage (15) étant disposé, lorsque le commutateur (S1) est ouvert, de manière à recevoir une tension de référence (Uref) provenant de la source (21) du circuit de réception (20).

2. Circuit selon la revendication 1, caractérisé en ce que le circuit d'échantillonnage (15) est un circuit d'échantillonnage et de maintien commandé à la même fréquence (fo) que le commutateur (S1) et comportant une sortie de tension de référence (16).

3. Circuit selon l'une quelconque des revendications 1 et 2, caractérisé en ce que le circuit de réception comprend un convertisseur analogique/numérique (22) comportant une entrée (ADO) branchée à la source de tension de référence (22) par l'intermédiaire d'un résistance (Rp).

4. Circuit selon l'une quelconque des revendications précédentes, caractérisé en ce que le signal de sortie (Ua) du détecteur est appliqué à une première entrée d'un comparateur (41) dont la seconde entrée reçoit un signal fluctuant entre deux valeurs déterminées par la tension de référence (Uref).

5. Circuit selon la revendication 4, caractérisé en ce que la seconde entrée du comparateur (41) est branchée à la sortie d'un circuit d'intégration (42) également branché à un circuit de seuil (43), ce circuit de seuil étant branché à la sortie du circuit d'échantillonnage (15) et déterminant les deux valeurs ci-dessus.

6. Circuit selon l'une quelconque des revendications 4 et 5, caractérisé en ce que l'alimentation du détecteur (10) est du type pulsé et en ce que la sortie du comparateur (41) présente un rapport de marquage/espacement (v) et commande un second commutateur (S2) fournissant, en régime pulsé, la tension de référence (Uref) au détecteur.

7. Circuit selon l'une quelconque des revendications 4 à 6, caractérisé en ce que la sortie du comparateur (41) est branchée à un diviseur de fréquence (35) dont la sortie commande le premier commutateur (S1) et le circuit d'échantillonnage (15).

8. Circuit selon l'une quelconque des revendications précédentes, caractérisé en ce que le détecteur est un compteur de masse d'air à film chaud.

FIG.1

FIG.2

FIG.3

FIG.4